# EUROPEAN PATENT APPLICATION

(11) **EP 4 580 056 A1**
(43) Date of publication of application: **02.07.2025**
(21) Application number: 23220871.0
(22) Date of filing: 30.12.2023
(51) Int. Cl.: H03K 17/0416, H03K 17/06, H03K 17/687, H03K 17/16

(54) **ELECTRONIC CIRCUIT INCLUDING A CASCODE CIRCUIT WITH TWO TRANSISTOR DEVICES**

(71) Applicant: Infineon Technologies Austria AG, 9500 Villach (AT)
(72) Inventor: KUTSCHAK, Matteo-Alessandro, 9072 Ludmannsdorf (AT); RIEGLER, Andreas, 9241 Wernberg (AT); WEBER, Hans, 9500 Villach (AT)
(74) Representative: Westphal, Mussgnug & Partner, Patentanwälte mbB

(57) **Abstract**

An electronic circuit, a half-bridge circuit, a power converter, and a method are disclosed. The electronic circuit includes a switching circuit (10). The switching circuit (10) includes a first transistor device (1) with a control node (11) and a load path between a first load path node (12) and a second load path node (13), a second transistor device (2) with a control node (21) and a load path between a first load path node (22) and a second load path node (23), and a series circuit with a third transistor device (3) and a voltage source (4) connected in series with a load path of the third transistor device (3). The first transistor device (1) is a normally-on device, the second transistor device (2) is a normally-off device, and the load paths of the first and second transistor devices (1, 2) are connected in series. The load path of the second transistor device (2) is connected between the control node (11) and the first load path node (12) of the first transistor device (1), and the series circuit is connected in parallel with the load path of the second transistor device (2).

## Description

This disclosure relates in general to an electronic circuit including a cascode circuit with two transistor devices, in particular a normally-on transistor device and a normally-off transistor device.

Each of a normally-on transistor device and a normally-off transistor device includes a drive input that is configured to receive a drive voltage for switching on or switching off the transistor device. A normally-on transistor device is in a conducting state (on-state) when the respective drive voltage is zero, and a normally-off transistor device is in a blocking state (off states) when the respective drive voltage is zero.

In many applications in which a transistor device is used as an electronic switch, normally-off devices are the preferred choice as these transistor devices are in a blocking state until they are actively switched on. On the other hand, normally-on transistor devices are in a conducting state until they are actively switched off. Especially during the start-up of an electronic circuit that includes a normally-on transistor device the normally-on behavior of the transistor device may cause dangerous conditions. If, for example, the normally-on transistor device is connected in series with a load and the series circuit with the transistor device and the load is powered before the normally-on transistor device is switched off a current may flow through the load in an uncontrolled fashion.

However, normally-on transistor devices, such as JFETs (Junction Field Effect Transistor), may have certain advantages over normally-off transistor devices, such as MOSFETs (Metal Oxide Semiconductor Field-Effect Transistors). Such advantages include, for example, a simpler and more cost-effective manufacturing process. Another advantage is the absence of a gate dielectric. In a MOSFET, the gate dielectric may degrade, which may result in a change of the device properties, such as the threshold voltage.

In a cascode circuit, a normally-on transistor device and a normally-off transistor can be connected with each other such that the cascode circuit operates as a normally-off device, so that the advantages of the normally-on transistor device can be used without having to accept the disadvantages. Usually, in a cascode circuit including a normally-on transistor device and a normally-off transistor device the normally-off transistor device is implemented to have a much lower voltage blocking capability than the normally-on transistor device, so that the cost of the normally-off transistor device are almost negligible as compared to the cost of the normally-on transistor device.

In a cascode circuit including a normally-on transistor device and a normally-off transistor device load paths of the transistor devices are connected in series. In one conventional cascode circuit, known as Baliga pair, the normally-on transistor device and the normally-off transistor device are connected such that the drive voltage of the normally-on transistor device equals the voltage across the load path of the normally-off transistor device. In this type of cascode circuit the switching state of the normally-off transistor device governs the switching state of the normally-on transistor device and, therefore, governs the switching state of the cascode circuit. It is difficult, however, in this type of cascode circuit to control a switching speed of the normally-on transistor device.

In another type of a conventional cascode circuit, the normally-on transistor device and the normally-off transistor device receive independent drive signals so that, when the normally-off transistor device is in an on-state, the switching speed of the normally on transistor device can be controlled by suitably generating the drive signal received by the normally-on transistor device. In the off-state of the normally-off transistor device, the normally-off transistor device ensures that the normally-on transistor device is also in the off-state. Two drive signals are required for driving this type of cascode circuit. Furthermore, when the transistor devices are implemented as N-type transistor devices, a positive voltage may be required to switch on the normally-off the wise and a negative voltage may be required to switch off (or maintain in the off-state) the normally-on transistor device. This increases the complexity of a drive circuit for driving the normally-on transistor device and the normally-off transistor device.

There is a need for an improved electronic circuit with a cascode circuit including an normally-on transistor device and a normally-off transistor device.

One example relates to an electronic circuit. The electronic circuit includes a switching circuit that includes a first transistor device having a control node and a load path between a first load path node and a second load path node, a second transistor device having a control node and a load path between a first load path node and a second load path node, and a series circuit including a third transistor device and a voltage source connected in series with a load path of the third transistor device. The first transistor device is a normally-on device and the second transistor device is a normally-off device. The load paths of the first and second transistor devices are connected in series, wherein the load path of the second transistor device is connected between the control node and the first load path node of the first transistor device. The series circuit is connected in parallel with the load path of the second transistor device.

Examples are explained below with reference to the drawings. The drawings serve to illustrate certain principles, so that only aspects necessary for understanding these principles are illustrated. The drawings are not to scale. In the drawings the same reference characters denote like features.
Figure 1 illustrates one example of an electronic circuit that includes a switching circuit with a first transistor device and a second transistor device arranged in a cascode circuit, and a series circuit including a third transistor device and a voltage source;
Figure 2 illustrates an electronic circuit with a switching circuit according to Figure 1 and a control circuit configured to control operation of the second and third transistor devices of the switching circuit;
Figure 3 illustrates one example of the control circuit in greater detail;
Figure 4 illustrates one example of the voltage source;
Figure 5 illustrates one example of an electronic circuit that includes the switching circuit as an electronic switch;
Figure 6 shows signal diagrams that illustrate one example of a method for operating the switching circuit in the electronic circuit according to Figure 4;
Figure 7 illustrates one example of a load circuit included in the electronic circuit according to Figure 5 in greater detail;
Figure 8 illustrates another example of an electronic circuit that includes the switching circuit as a rectifier element;
Figure 9 shows signal diagrams that illustrate one example of a method for operating the switching circuit in the electronic circuit according to Figure 8;
Figure 10 illustrates one example of a load circuit included in the electronic circuit according to Figure 7 in greater detail;
Figure 11 illustrates one example of a switching circuit that, in addition to the first, second, and third transistor devices includes a fourth transistor device connected in parallel with the cascode circuit;
Figure 12 illustrates an electronic circuit that includes the switching circuit according to Figure 11 as a rectifier element;
Figure 13 shows signal diagrams that illustrate one example of a method for operating the switching circuit according to Figure 12;
Figure 14 illustrates an electronic circuit that includes a first switching circuit of the type illustrated in Figure 11 as a low-side switch and a second switching circuit of the type illustrated in Figure 11 as a high-side switch;
Figure 15 shows signal diagrams that illustrate one example of a method for operating the electronic circuit according to Figure 14;
Figures 16 and 17 illustrate examples of control units that may be used in control circuit according to Figure 15 for generating drive signals of the transistor devices based on control signals;
Figure 18 shows a modification of the electronic circuit according to Figure 14;
Figure 19 shows signal diagrams that illustrate one example of a method for operating the electronic circuit according to Figure 18;
Figure 20 illustrates one example of a semiconductor package that includes a first, a second, and a third transistor device; and
Figure 21 illustrates an equivalent circuit diagram of the semiconductor package according to Figure 20.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

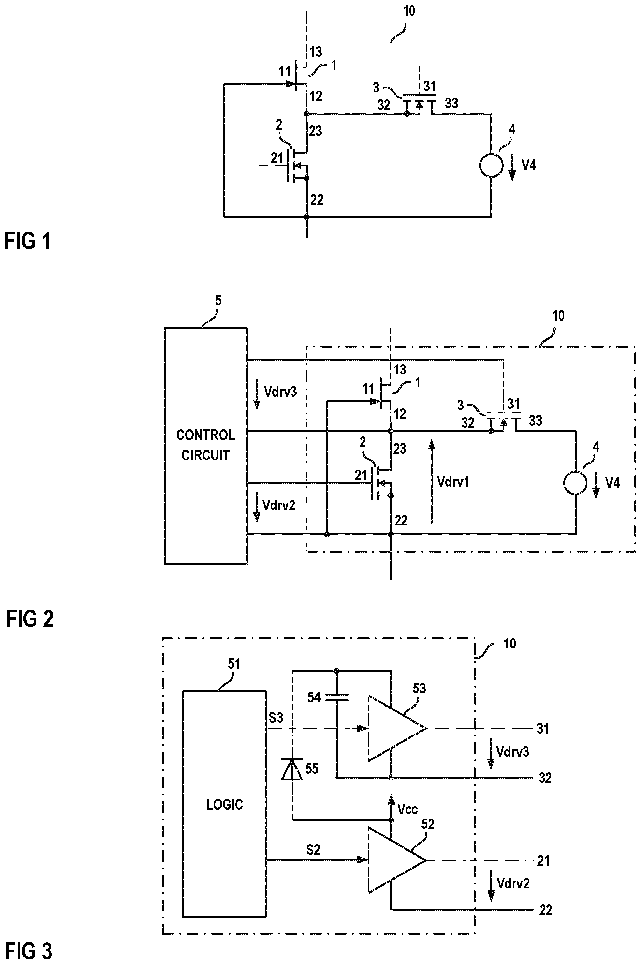

Figure 1 illustrates one example of an electronic circuit. This electronic circuit may be used as an electronic switch and is therefore also referred to as switching circuit 10. The electronic circuit includes a first transistor device 1 and a second transistor device 2. Each of the first and second transistor devices 1, 2 includes a control node 11, 21, and a load path between a first load path node 12, 22 and a second load path node 13, 23. The first and second transistor devices 1, 2 form a cascode circuit. This includes that the load paths of the first and second transistor devices 1, 2 are connected in series.

Furthermore, the load path of the second transistor device 2 is connected between the control node 11 and the first load path node 12 of the first transistor device 1. For this, the control node 11 of the first transistor device 1 is connected to the first load path node 22 of the second transistor device 2, which is that one of the two load path nodes 22, 23 of the second transistor device 2 that faces away from the load path of the first transistor device 1. In this example, the load paths of the first and second transistor devices 1, 2 are connected in series by having the first load path node 12 of the first transistor device 1 connected to the second load path node 23 of the second transistor device 2.

Furthermore, the switching circuit includes a series circuit with a third transistor device 3 and a voltage source 4. The series circuit including the third transistor device 3 and the voltage source 4 is connected in parallel with the load path of the second transistor device 2. The third transistor device 3 includes a control node 31 and a load path between a first load path node 32 and a second load path node 33. The voltage source 4 being connected in series with the third transistor device 3 includes that the voltage source 4 is connected in series with the load path of the third transistor device 3. A voltage V4 provided by the voltage source 4 is referred to as depletion voltage in the following.

In the switching circuit according to Figure 1, the first transistor device 1 is a normally-on device and the second transistor device 2 is a normally-off device. According to one example, the third transistor device 3 is a normally-off device.

Just for the purpose of illustration, in the example illustrated in Figure 1, the first transistor device 1 is a JFET. This, however, is only an example. Any other kind of normally-on device, such as a GaN HEMT (Heterojunction High-Mobility Transistor) or a depletion MOSFET, may be used as well. According to one example, the JFET is a silicon JFET (Si JFET). According to another example, the JFET is a silicon carbide JFET (SiC JFET). According to one example, the JFET is a superjunction JFET.

Just for the purpose of illustration, in the example illustrated in Figure 1, each of the second and third transistor devices 2, 3 is a MOSFET. This, however, is only an example. Other kinds of normally-off devices may be used as well.

Each of the transistor devices 1, 2, 3 illustrated in Figure 1 is a voltage controlled transistor device that switches on or off dependent on a drive voltage received at a respective drive input. According to one example, the drive input includes the respective control node 11, 21, 31 and the respective first load path node 12, 22, 32. In the JFET forming the first transistor device 1 and the MOSFETs forming the first and second transistor devices 2, 3, a gate node forms the control node 11, 21, 31, a source node forms the first load path node 12, 22, 32, and a drain node forms the second load path node 13, 23, 33. In this example, the drive voltage may also be referred to as gate-source voltage.

Controlling the switching circuit 10 with the first, second, and third transistor devices 1, 2, 3 includes controlling operation of the second and third transistor devices 2, 3 by providing a suitable drive voltage Vdrv2, Vdrv3 to the respective drive input. This is explained with reference to Figure 2 in the following.

Figure 2 illustrates an electronic circuit with a switching circuit 10 of the type illustrated in Figure 1 and a control circuit 5 configured to control operation of the second and third transistor devices 2, 3. The control circuit 5 is configured to generate a second drive voltage Vdrv2 received by the drive input of the second transistor device 2, and a third drive voltage Vdrv3 received by the drive input of the third transistor device 3. A first drive voltage Vdrv1 received by the drive input of the first transistor device 1 equals a voltage across the load path of the second transistor device 2 and is governed by the switching state of the second transistor device 2.

Each of the first, second, and third transistor devices 1, 2, 3 is in an on-state (conducting state) or an off-state (blocking state) dependent on a voltage level of the respective drive voltage Vdrv1, Vdrv2, Vdrv3. Just for the purpose of illustration, the first transistor device 1 is an N-type transistor devices. In this example, the first transistor device 1 is in the on-state when the first drive voltage Vdrv1 is higher (more positive) than a negative threshold voltage. The threshold voltage is between -5V and -20V, for example. Due to the negative threshold voltage, the first transistor device 1 is in the on-state when the drive voltage Vdrv1 is zero. Furthermore, in the example illustrated in Figures 1 and 2, the second and third transistor device 2, 3 are N-type transistor devices. In this example, each of these transistor devices 2, 3 is in the on-state when the respective drive voltage Vdrv2, Vdrv3 is higher (more positive) than a positive threshold voltage. The threshold voltage is between 2V and 10V, for example. Due to the positive threshold voltage, each of the second and third transistor devices 2, 3 is in the off-state when the respective drive voltage Vdrv2, Vdrv3 is zero.

According to one example, a voltage blocking capability of the first transistor device 1 is significantly higher than the voltage blocking capability of the second transistor device 2. According to one example, the voltage blocking capability of the first transistor device 1 is between 100 V and 1500 V. The voltage blocking capability of the second transistor device 2 is higher than the magnitude of the threshold voltage of the first transistor device and is selected from between 20 V and 60 V, for example. The first transistor device 1 may also be referred to as high-voltage device, and the second transistor device 2 may also be referred to as low-voltage device.

Referring to Figure 2, the second drive voltage Vdrv2 received by the drive input of the second transistor device 2 is a voltage that is referenced to the first load path node (source node) 22 of the second transistor device 2. The third drive voltage Vdrv3 received by the drive input of the third transistor device 3 is a voltage that is referenced to the first load path node (source node) 32 of the third transistor device 3.

Figure 3 illustrates one example of the control circuit 5 that is configured to control operation of the first transistor device 2 and the second transistor device 3. Referring to Figure 3, the control circuit includes a logic circuit 51 that is configured to output a first control signal S2 for controlling operation of the second transistor device 2 and a second control signal S3 for controlling operation of the second transistor device number 3. A first drive circuit 52 receives the first control signal S2 and is configured to output the second drive voltage Vdrv2 dependent on the first control signal S2 such that the second drive voltage Vdrv2 is higher than the threshold voltage of the second transistor device 2 when the first control signal S2 indicates that the second transistor device 2 is to be switched on. When the first control signal S2 indicates that the second transistor device 2 is to be switched off, the first drive circuit 52 generates the second drive voltage Vdrv2 such that a voltage level of the second drive voltage Vdrv2 is below the threshold voltage, such as zero. Referring to Figure 3, the first drive circuit 52 receives a driver supply voltage Vcc, which is a voltage that is referenced to the first load path node (source node) 22 of the second transistor device 2, for example. A voltage level of the driver supply voltage Vcc is high enough for the first drive circuit 52 to generate the second drive voltage Vdrv2 such that the second drive voltage Vdrv2 either has a voltage level higher than the threshold voltage (in order to switch on the second transistor device 2) or a voltage level lower than the threshold voltage of the second transistor device Vdrv2 (in order to switch off the second transistor device 2).

Referring to Figure 3, a second drive circuit 53 receives the second control signal S3 and is configured to output the third drive voltage Vdrv3 dependent on the second control signal S3 such that the third drive voltage Vdrv3 is higher than the threshold voltage of the third transistor device 3 when the second control signal S3 indicates that the third transistor device 3 is to be switched on. When the second control signal S3 indicates that the second transistor device 3 is to be switched off, the second drive circuit 53 generates the third drive voltage Vdrv3 such that a voltage level of the third drive voltage Vdrv3 is below the threshold voltage of the third transistor device, such as zero.

A supply voltage received by the second drive circuit 53 is derived from the driver supply voltage Vcc received by the first drive circuit 52. The supply voltage of the second drive circuit 53 is provided by a supply capacitor 54 that is connected to the supply node through a diode 55. The second and third transistor devices 2, 3 form a half-bridge circuit in which the second transistor device 2 is a low-side switch (low-side transistor) and the third transistor device is a high-side switch (high-side transistor). The capacitor 54 and the diode 55 form a bootstrap circuit in which the capacitor 54 is charged each time by the driver supply voltage Vcc when the second transistor device 2 is in the on-state. After the bootstrap capacitor 54 has been charged, the bootstrap capacitor 54, in a conventional way, provides a floating supply voltage that enables the second drive circuit 53 to generate the third drive voltage Vdrv3 independent of the electrical potential at the first load path node (source node) 32 of the third transistor device.

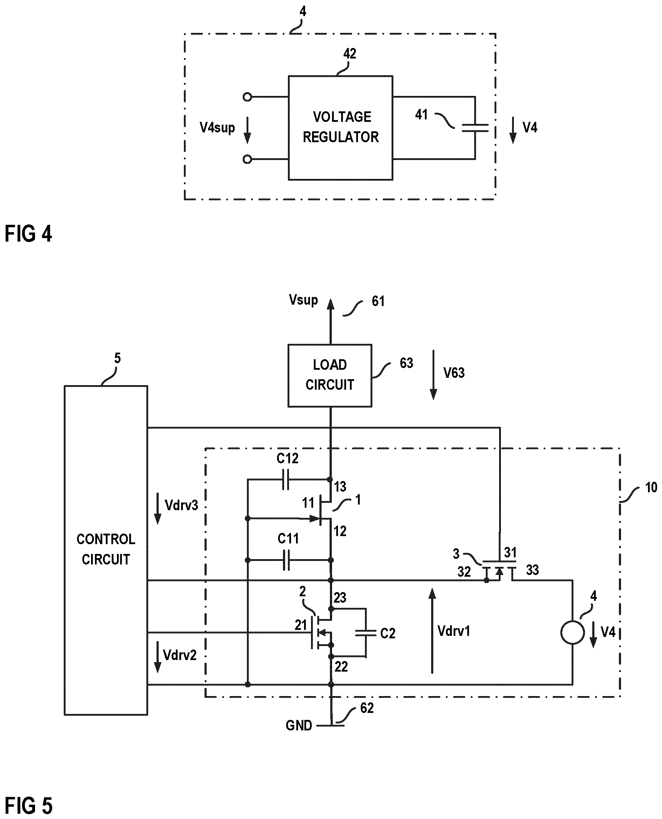

The voltage source 4 can be implemented like a conventional voltage source and may be configured to provide an essentially constant depletion voltage V4. According to one example illustrated in Figure 4, the voltage source includes a capacitor 41 across which the depletion voltage V4 is available, and a voltage regulator 42 that receives a supply voltage S4sup and is configured to regulate the voltage across the capacitor 41 to be essentially constant.

The switching circuit 10 can be operated in an on-state and an off-state. In the on-state, the cascode circuit including the first and second transistor devices 1, 2 is conducting. More specifically, each of the first and second transistor devices 1, 2 is conducting, so that a current can flow through the load paths of the first and second transistor devices 1, 2. In the off-state, the cascode circuit is blocking. More specifically, each of the first and second transistor devices 1, 2 is blocking, so that a current flow through the cascode circuit is prevented. The switching circuit 10, which is capable of operating in the on-state or the off-state, can be used as an electronic switch in various kinds of circuit applications. One example is illustrated in Figure 5.

Figure 5 illustrates one example of an electronic circuit in which the switching circuit 10 is connected in series with a load circuit 63. The series circuit including the load circuit 63 and the switching circuit 10 is connected between first and second supply nodes 61, 62 between which a supply voltage Vsup is available. According to one example, the supply voltage Vsup is referenced to a reference node GND, such as ground. Just for the purpose of illustration, in the circuit according to Figure 5, the switching circuit 10 acts as a low-side switch connected between the load circuit 63 and the second supply node 62 forming the reference node GND. This, however, is only an example. According to another example (not illustrated) the switching circuit 10 is a high-side switch connected between the load circuit 63 and the first supply node 61.

In the electronic circuit according to Figure 5, the switching state of the switching circuits 10 governs a load voltage V63 across the load circuit. When the switching circuit 10 is in the on-state, the load voltage V63 essentially equals the supply voltage Vsup (when a voltage drop across the switching circuit 1 due to an on-resistance of the switching second 10 is neglected). When the switching circuit 10 is in the off-state, the load voltage V63 is essentially zero and the supply voltage Vsup drops across the switching circuits 10, in particular across the cascode circuit including the first and second transistor devices 1, 2.

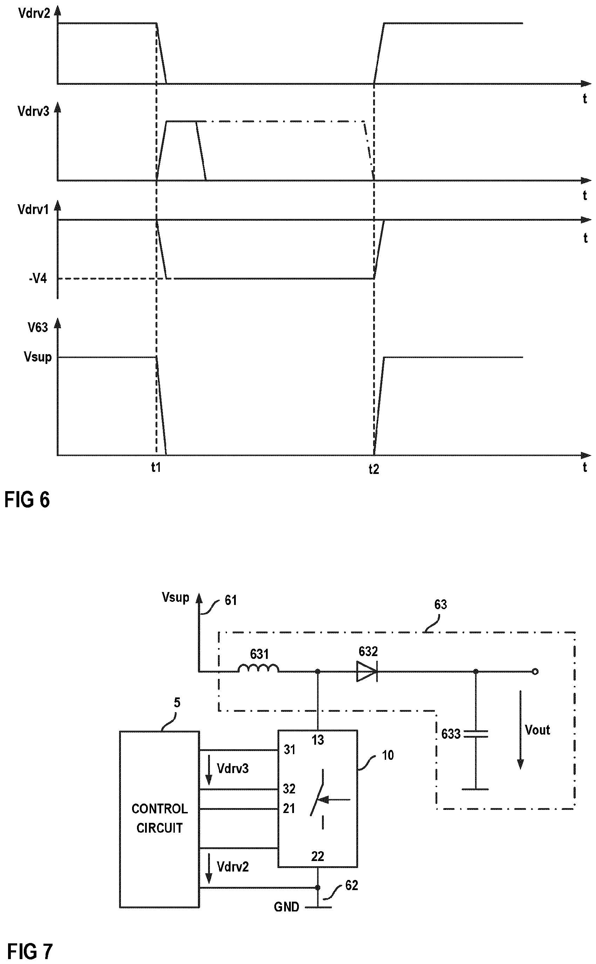

Figure 6 shows signal diagrams that illustrate one method for operating the electronic circuit according to Figure 5, in particular for operating the switching circuit 10. More specifically, Figure 6 shows signal diagrams of the first, second, and third drive voltages Vdrv1, Vdrv2, Vdrv3 and the load voltage V63. The signal diagrams illustrated in Figure 5 start at a time instance at which the switching circuits 10 is in the on-state. This includes that the second transistor device 2 is in the on-state and the third transistor device 3 is in the off-state. For this, the control circuit 5 generates the second drive voltage Vdrv2 to be higher than the threshold voltage of the second transistor device 2 and generates the third drive voltage Vdrv3 to be lower than the threshold voltage of the third transistor device 3, such as zero. Due to the conducting second transistor device 2 the first drive voltage Vdrv1 is essentially zero, so that the first transistor device 1 is conducting and a current can flow through the cascode circuit including the first and second transistor devices 1, 2. As illustrated in Figure 6, during the on-state of the switching circuit 10, the load voltage V63 essentially equals the supply voltage Vsup.

At a first time instance t1 illustrated in Figure 6, the switching circuit 10 starts to switch off so that the load voltage V63 finally essentially drops to zero. For this, the control circuit 5 switches off the second transistor device 2 at the first time instance t1 and switches on the third transistor device 3. There may be a short delay time between switching off the second transistor device 2 and switching on the third transistor device 3 in order to prevent the voltage source 4 from being short-circuited. Such delay time, however, is not illustrated in Figure 6. Switching on the third transistor device 3 connects the voltage source 4 in parallel with the load path of the blocking second transistor device 2, so that the first drive voltage Vdrv1 essentially equals the inverted (negated) depletion voltage V4.

In a conventional switching circuit that includes a cascode circuit of the type illustrated in Figures 1, 2 and 4 and that does not include the third transistor device 3 and the voltage source 4 for providing the depletion voltage V4, the first drive voltage Vdrv1 adjusts to a voltage level that is dependent on a voltage across the cascode circuit and on capacitances C11, C12, C2 of the first and second transistor devices 1, 2. These capacitances C11, C12, C2 include a first capacitance C11 and a second capacitance C12 of the first transistor device 1 and a capacitance 2 of the second transistor device 2. The first capacitance C11 is a capacitance between the control node (gate node) 11 and the first load path node (source node) 12 and the second capacitance 12 is a capacitance between the control node 11 and the second load path node (drain node) 13 of the first transistor device 1. The capacitance C2 of the second transistor device 2 is a capacitance C2 between the second load path node (drain node) 23 and the first load path node (source node) 22 of the second transistor device 2. In the off-state of the switching circuits 10, the load path of the first transistor device 1 and the load path of the second transistor device 2 are electrically interrupted. In a switching circuit that is devoid of the third transistor device 3 and the voltage source 4 the first drive voltage Vdrv1 is dependent on the voltage across the switching circuit 10 and dependent on the capacitances in the capacitance network including the capacitances C11, C12, C2.

As the voltage across the cascode circuit may vary and as the capacitances C11, C12, C2 may vary due to variations in the manufacturing process of the transistor devices 1, 2, the first drive voltage Vdrv1 may vary.

In the switching circuit 10 according to Figure 5, that includes the third transistor device 3 and the voltage source 4 connected in series with the third transistor device 3, the first drive voltage Vdrv1 is defined by the depletion voltage V4 when the switching circuit 10 is in the off-state. In this way, the drive voltage Vdrv1 is essentially fixed and, in particular, can be adjusted to be lower (more negative) than for a cascode circuit that does not include the third transistor device 3 and the voltage source 4. Furthermore, the first drive voltage Vdrv1 is fixed to the voltage V4 provided by the voltage source 4 as long as the third transistor device number 3 is in the on-state, so that there are no variations of the first drive voltage Vdrv1 that may result from variations of the voltage across the cascode circuit. Thus, oscillations of the first drive voltage Vdrv1 are less likely to occur.

Moreover, in the electronic circuit according to Figure 5, a slope of the first drive voltage Vdrv1 can be adjusted by suitably adjusting the switching speed of the third transistor device 3.

Referring to Figure 6, for switching on the switching circuit 10, the control circuit 5 switches on the second transistor device 2 at a second time instance t2. The third transistor device 3 is switched off such that the third transistor device 3 is in the off-state when the second transistor device 2 switches on. That is, the third transistor device 3 may be switched off just short enough before the second time instance t2 to prevent the voltage source from being short-circuited (as illustrated in dashed and doted lines in Figure 6). According to another example (illustrated in solid lines in Figure 6) the third transistor device 3 is switched off a predefined time period after having been switched on and before the second time instance t2. Due to the blocking first transistor device 1 the first drive voltage Vdrv1 is essentially maintained at the voltage level that is given by the inverted depletion voltage V4 after the third transistor device 3 has been switched off.

The load circuit 63 illustrated in Figure 5 may be implemented in various ways. One example of the load circuit 63 is illustrated in Figure 7. In this example, the load circuit 63 includes an inductor 631 connected in series with the switching circuit 10 and a series circuit including a rectifier element 632 and a capacitor 633 connected in parallel with the switching circuit 10. In this example, the switching circuit 10 together with the load circuit 63 forms a power converter that is configured to provide an output voltage Vout across the capacitor 633. Just for the purpose of illustration, the power converter is a boost converter in this example The control circuit 5 may receive a feedback signal (not illustrated) that represents the output voltage Vout and may be configured to adjust a duty cycle of operating the switching circuit 10 in the on-state and the off-state such that the output voltage Vout is regulated to have a desired voltage level.

It should be noted that Figure 7 illustrates a simple version of a boost converter. It goes without saying that the switching circuit 10 may be used as an electronic switch in any kind of boost converter. Furthermore, the switching circuit 10 is not restricted to be used as an electronic switch in a boost converter but may be used as an electronic switch in other type of power converter such as, for example, a buck converter or flyback converter as well. Moreover, the switching circuit 10 is not restricted to be used as an electronic switch in a power converter but may be used as an electronic switch in any other type of switching application as well.

Furthermore, the switching circuit 10 explained herein before is not restricted to be used as an electronic switch but may be used as a rectifier element as well. For this, the second transistor device 2 may be implemented as a unidirectionally blocking transistor device. A unidirectionally blocking transistor device is a transistor device that, in the off-state, is configured to block when the voltage across the transistor device has a first polarity and is configured to conduct when the voltage has a second polarity opposite the first polarity. One example of a unidirectionally blocking transistor device is a MOSFET such as the MOSFET forming the second transistor device 2 in the examples explained herein before. The MOSFET includes an internal body diode which causes the MOSFET to conduct independent of the drive voltage when a voltage is applied between the first and second load path nodes that has a polarity such that the body diode is forward biased. The N-type MOSFET forming the second transistor device 2 illustrated in Figures 1 and 2 conducts when the second transistor device 2 is operated such that a voltage between the first and second load path nodes ( source and drain nodes) 22, 23 is positive. In this operating state, the first drive voltage Vdrv1 essentially equals the forward voltage of the body diode of the second transistor device 2. In a silicon-based second transistor device 2 this voltage is about 0.7V and causes the first transistor device 1 to conduct, so that a current can flow through the cascode circuit including the first and second transistor devices 1, 2.

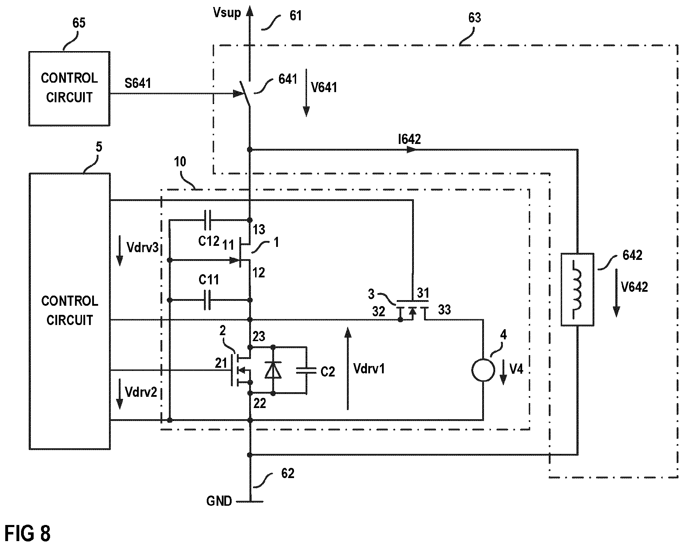

Figure 8 illustrates one example of an electronic circuit in which the switching circuit 10 operates as a rectifier element. A load circuit 63 connected to the switching circuit 10 includes an electronic switch 641 connected in series with the cascode circuit including the first and second transistor devices 1, 2. The series circuit including the electronic switch 641 and the cascode circuit is connected between the first and second supply nodes 61, 62. In the example illustrated in Figure 8, the electronic switch 641 and the switching circuits 10 form a half-bridge. The switching circuit 10 forms the low-side part (a low-side switch) and the electronic switch 641 forms the high-side part (high-side switch) of the half-bridge.

Just as an example, the switching circuit 10 is connected between the electronic switch 641 and the second supply node (reference node) 62. Additionally, the load circuit 63 includes an inductor circuit 642 that is connected in parallel with the switching circuit 10. This includes that the inductor circuit 642 is connected in parallel with the cascode circuit including the first and second transistor devices 1, 2. The inductor circuit 642 includes at least one inductor connected in series with the electronic switch 641. One example of the inductor circuit 642 is explained herein further below.

Referring to Figure 8, the electronic circuit further includes a control circuit 65 that is configured to control operation of the electronic switch 641. The control circuit 65 is configured to output a control signal S641 that is configured to switch on or off the electronic switch 641. The electronic switch 641 can be a conventional electronic switch and may include, for example, a transistor such as a MOSFET, an IGBT (Insulated Gate Bipolar Transistor), or a HEMT.

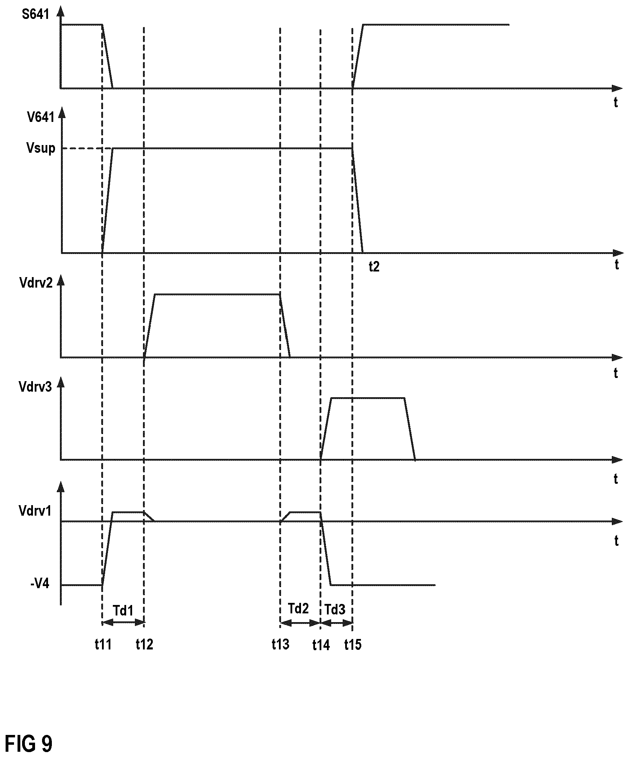

The electronic circuit according to Figure 8 can have two operating states, a first operating state in which the electronic switch 641 is conducting, and a second operating state in which the electronic switch 641 is blocking. In the first operating state, the switching circuit 10 is operated to be in the off-state, so that a load current I642 flows through the series circuit including the electronic switch 641 and the inductor circuit 642 between the supply nodes 61, 62 and bypasses the switching circuit 10. In the second operating state, after the electronic switch 641 has been switched off, the inductor circuit 641 maintains the load current I642 and forces the load current 1642 to flow through the switching circuit 10. In this operating state, the switching circuit 10 acts as a freewheeling element or rectifier element. Operating the switching circuit 10 when the switching element 641 is in the off-state is explained below with reference to Figure 9.

Figure 9 shows signal diagrams of the switch control signal S641, a voltage V641 across the electronic switch 641 and the drive voltages Vdrv1, Vdrv2, Vdrv3 of the first, second, and third transistor devices 1, 2, 3 of the switching circuit 10. Before a first time instance t11 illustrated in Figure 9, the electronic circuit is in the first operating state, which includes that the electronic switch 641 is conducting and the switching circuit 10 is in the off-state. The electronic switch 641 is conducting when the control signal S641 has an on-level that switches on the electronic switch 641. Just for the purpose of illustration, the on-level of the control signal S641 is a high signal level in the example illustrated in Figure 9. The switching circuit 10 being in the off-state includes that second and third transistor devices 2, 3 are in the off-state. In the first operating state of the electronic circuit, the voltage V641 across the electronic switch 641 is essentially zero and a voltage V642 (not illustrated in Figure 9) across the inductor circuit 642 essentially equals the supply voltage Vsup.

At the first time instance t11 illustrated in Figure 9, the electronic switch 641 starts to switch off, which includes that the control signal S641 changes from the on-level to an off-level. At this time, the voltage V641 across the electronic switch 641 starts to increase and finally reaches a voltage level that essentially equals the supply voltage Vsup. For a first delay time Td1 after the first time instance t11 the switching circuit 10 remains in the off-state. The first delay time Td1 is between 10 nanoseconds (ns) and 60 ns, in particular between 20 ns and 50 ns, for example. A short time period after the first time instance t11 the voltage across the second transistor device 2 reaches the forward voltage of the body diode of the MOSFET forming the second transistor device 2, so that the body diode of the MOSFET forming the second transistor device 2 is conducting. The forward voltage of the body diode included in the second transistor device 2 equals the first drive voltage Vdrv1 and causes the first transistor device 1 to be in the on-state, so that the cascode circuit including the first and second transistor devices 1, 2 takes over the load current 1642.

The first delay time Td1 ensures that the electronic switch 641 and the switching circuit 10 are not switched on at the same time and, therefore, helps to avoid a cross current through the series circuit including the electronic switch 641 and the switching circuit 10.

The body diode of the second transistor device 2 is an internal diode. For illustration purposes, in Figure 8, this body diode is explicitly illustrated as a diode connected between the source and drain node 22, 23 of the MOSFET.

Referring to Figure 9, after the first delay time Td1, which is at a second time instance t12, the second transistor device 2 starts to switch on. That is, the drive signal Vdrv2 of the second drive signal Vdrv2 starts to increase. The second transistor device 2 switches on a short time period after the second time instance 112. Switching on the second transistor device 2 slightly decreases the first drive voltage Vdrv1 but maintains the first transistor device 1 in the on-state. On the other hand, switching on the second transistor device 2 significantly reduces losses caused in the second transistor device 2 due to the load current I642 as compared to operating the second transistor device 2 such that the body diode is conducting. After switching on the second transistor device 2 the load current continues to flow through the cascode circuit with the first and second transistor devices 1, 2.

Referring to Figure 9, the second transistor device 2 is switched off before the electronic switch 641 switches on for the next time. In the example illustrated in Figure 9, the second transistor device 2 starts to switch off at a third time instance t13 and is in the off-state a short time period after the third time instance t13 and before a fifth time instance t15 at which the electronic switch 641 again switches on. When the second transistor device 2 switches off, the body diode of the second transistor device 2 takes over the load current I642 and maintains the first transistor device 1 in the on-state. After a second delay time Td2, which is at a fourth time instance t14 in the example illustrated in Figure 9, the third transistor device 3 starts to switch on and is in the on-state a short time period after the fourth time instance t14. According to one example, the second delay time Td2 is selected from the same range as the first delay time Td1 explained hereinabove. According to one example, the second delay time Td2 is essentially zero, so that the second transistor device 2 start to switch off and the third transistor device 3 starts to switch on at the same time. In this example, the third and fourth time instances t13, t14 are essentially identical.

The fourth time instance t14 is before the fifth time instance t15 at which the electronic switch 641 switches on. A time period between the fourth and fifth time instances t14, t15 is referred to as third delay time Td3 in the following. According to one example, the third delay time Td3 is selected from a range of between 1 microsecond (µs) and 5 µs.

When the third transistor device 3 switches on, the first drive voltage Vdrv1 decreases to be essentially equal to the negated depletion voltage V4, so that the first transistor device 1 switches off and the body diode of the MOSFET forming the second transistor device 2 is reverse biased. After the switching circuit 10 has been switched off and before the electronic switch 641 switches on, the load current 1642 flows vias the voltage source 4 and charges the first and second capacitances C11, C12 of the first transistor device 1.

The series circuit including the first transistor device 3 and the voltage source 4 helps to reduce switching losses in the cascode circuit of the switching circuit 10 as compared to a conventional switching circuit that does not include a series circuit with a transistor device and a voltage source of the type illustrated in Figure 8. This is explained with reference to Figure 8 in the following.

Referring to the above, the first and second transistor devices 1, 2 include capacitances C11, C12, C2. The first transistor device 1, which is implemented as a JFET in the example illustrated in Figure 8, internally includes a PN junction between the gate node 11 and the source and drain nodes 12, 13. The first and second capacitances C11, C12 are essentially junction capacitances of the PN junction. The second transistor device 2, which is implemented as a MOSFET in the example illustrated in Figure 8, internally includes the body diode explained before between the source node 22 and the drain node 23. The capacitance C2 is essentially a junction capacitance of the body diode and may also be referred to as drain-source capacitance. Further capacitances of the second transistor device 2, such as a gate-source capacitance or a gate-drain capacitance, are not illustrated in Figure 8.

As can be seen from Figure 8, the first capacitance C1 of the first transistor device 1 and the capacitance C2 of the second transistor device 2 are connected in parallel with each other and are connected in parallel with the series circuit including the third transistor device 3 and the voltage source 4.

Switching off the first and second transistor devices 1, 2 is associated with charging the capacitances C11, C12, C2. Charging the capacitances C11, C12, C2 is associated with a respective charging current flowing into the capacitances C11, C12, C2. Each of the charging currents is associated with a respective loss. Basically, the higher the voltage across a circuit path in which the charging current flows the higher the loss.

A conventional electronic circuit includes a switching element in accordance with the switching element 641 according to Figure 8 and a switching circuit 10 with a cascode circuit in accordance with the cascode circuit including the first and second transistor devices 1, 2 according to Figure 8 and does not include a series circuit with a third transistor device 3 and a voltage source 4 according to Figure 8. In the conventional electronic circuit, the charging current for charging capacitances, such as capacitances C11, C12, C2, of the cascode transistors 1, 2 is provided by the power source that provides the supply voltage across the series circuit including the electronic switch 641 and the cascode circuit 1, 2. This voltage may be in the range of several 100V, so that the charging currents for charging the capacitances in the cascode circuit may cause significant losses.

In the switching circuit 10 according to Figure 8, the charging current for charging the first capacitance C11 of the first transistor device 1 and the capacitance C2 of the second transistor device 2 is provided by the voltage source 4. According to one example, the depletion voltage V4 provided by the voltage source 4 is significantly lower than the supply voltage Vsup across the series circuit including the switching element 641 and the cascode circuit 1, 2. According to one example, the depletion voltage is less than 10% or even less than 5% of the supply voltage Vsup. According to one example, the supply voltage Vsup is between 400V and 880V, for example, and the depletion voltage is between 20V and 40V, for example.

In the electronic circuit according to Figure 8, when the switching element 641 switches on at the fifth time t15, the capacitances C11, C12 and C2 of the first and second transistor devices 1, 2 have already been charged by the voltage source 4 such that these transistor devices 1, 2 are in the off-state. Switching on the switching element 641 causes the voltage across the cascode circuit to further increase, so that the voltage across the cascode circuit essentially equals the supply voltage.

Moreover, in the electronic circuit according to Figure 8, the series circuit including the third transistor device 3 and the voltage source 4, in particular the series circuit including the body diode of the second transistor device 3 and the voltage source 4, acts as a clamping circuit that limits the voltage across the load path of the second transistor device 2 to a voltage level that is essentially given by the forward voltage of the body diode of the second transistor device plus the depletion voltage V4. This clamping circuit helps to prevent an Avalanche breakdown of the second transistor device 2.

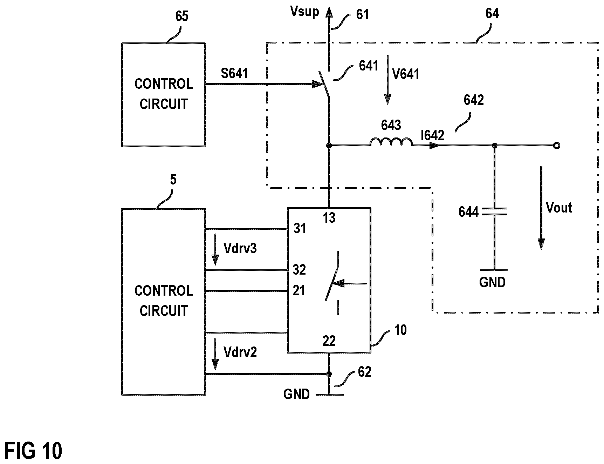

Figure 10 illustrates one example of the inductor circuit 642 in the electronic circuit according to Figure 8. In this example, the inductor circuit 642 includes a series circuit including an inductor 643 and a capacitor 644, wherein the series circuit is connected in series with the switching element 641 and in parallel with the switching circuit 10. In this example, the switching circuit 10, the switching element 641 and the inductor circuit 642 form a buck converter that provides an output voltage Vout across the capacitor 644. The output voltage Vout can be regulated by the control circuit 65 controlling operation of the switching element 641 by suitably adjusting a duty cycle of a switched mode operation of the switching element 641. For this, the control circuit 65 may receive a feedback signal representing a voltage level of the output voltage Vout. Such type of operation is commonly known, so that no further explanation is provided in this regard.

It should be noted that the switching circuit 10 of the type explained herein before is not restricted to be used as a rectifier element in a buck converter of the type illustrated in Figure 10. The switching circuit 10 may be used as a rectifier element in any kind of Electronic circuit, in particular, in any kind of power converter. According to one example, a switching circuit of the type explained herein before is used as a rectifier element in a boost converter of the type illustrated in Figure 7. That is, in the boost converter according to Figure 7, the rectifier element 632 may be replaced by a switching circuit including a first transistor device and a second transistor device of the type explained herein before. The switching circuit 10 illustrated in Figure 7 may be used in addition to the switching circuit operating as a rectifier element. Alternatively, the switching circuit 7 is replaced by a conventional electronic switch.

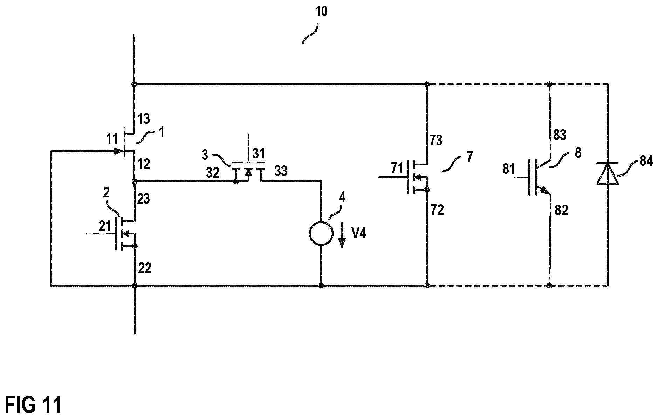

Figure 11 shows a modification of the switching circuit 10 explained herein before. The switching circuit 10 according to Figure 11, in addition to the cascode circuit with the first and second transistor devices 1, 2 and the series circuit with the second transistor device 3 and the voltage source 4 includes a fourth transistor device 7. The fourth transistor device 7 includes a load path between a first load path node 72 and a second load path node 73, wherein the load path is connected in parallel with the cascode circuit. According to one example, the fourth transistor device 7 is a normally-off transistor device. According to one example, the fourth transistor device 7 is a MOSFET, so that the first load path node 72 is a source node of the MOSFET and the second load path node 73 is a drain node of the MOSFET. According to one example, the MOSFET forming the fourth transistor device 7 is a superjunction MOSFET. According to one example, the second and fourth transistor devices 2, 7 are MOSFETs of the same conductivity type. Just for the purpose of illustration, the second and fourth transistor devices 2, 7 are N-type MOSFETs in the example illustrated in Figure 11.

According to one example, the fourth transistor device 7 is a silicon (Si) MOSFET. According to one example, the MOSFET forming the fourth transistor device 7 is a superjunction MOSFET. According to one example, the first transistor device 1 is a JFET. The JFET 1 is either a silicon (Si) JFET or a silicon carbide (SiC) JFET. The second transistor device 2 is a silicon MOSFET, for example.

The switching circuit 10 according to Figure 11 may be operated such that the cascode circuit including the first and second transistor devices 1, 2 and the fourth transistor device 7 are in the on-state at the same time, so that a load current through the switching circuits 10 flows through the parallel circuit including the cascode circuit and the fourth transistor device 7. According to one example, the on-resistance of the fourth transistor device 7 is essentially equal to the on-resistance of the cascode circuit. According to another example, the on-resistance of the fourth transistor device 7 is lower than the on-resistance of the cascode circuit. In this example, in the on-state of both the cascode circuit and the fourth transistor device 7, the fourth transistor device 7 takes over the majority of the load current. According to one example, the on-resistance of the fourth transistor device 7 is less than 100%, less than 50%, less than 30%, or even less than 10% of the on-resistance of the cascode. The on-resistance of the fourth transistor device 7 is the electrical resistance of the load path of the fourth transistor device 7 in the on-state, and the on-resistance of the cascode circuit is the electrical resistance of the series circuit including the load paths of the first and second transistor devices 1, 2 in the on-state of the cascode circuit.

Optionally, as illustrated in dashed lines in Figure 11, the switching circuit 10 includes a further transistor device 8, such as an IGBT. A load path (collector-emitter path) between a collector node 83 and an emitter node 82 of the IGBT 8 is connected in parallel with the cascode circuit and is connected in parallel with the load path of fourth transistor device 7. A gate node 81 and the emitter node 82 of the IGBT 8 form a drive input, so that the IGBT 8 switches on or off dependent on a drive voltage received between the gate node 81 and the emitter node 82.

According to one example, the IGBT 8 is a reverse blocking IGBT. In this example, a diode 84, such as an EMCON (Emitter Controlled) diode is connected in parallel with the load path of the IGBT. The diode 84 is connected in parallel with the load path of the IGBT 8 such that the diode takes over a current when a reverse biasing voltage is applied to the IGBT 8. A reverse biasing voltage is a positive voltage between the emitter node and the cathode node of the IGBT. The diode 84 is connected in parallel with the series circuit including the body diode of the second transistor device 2 and the load path of the first transistor device 1. Furthermore, the diode 84 is connected in parallel with a body diode of the fourth transistor device 7.

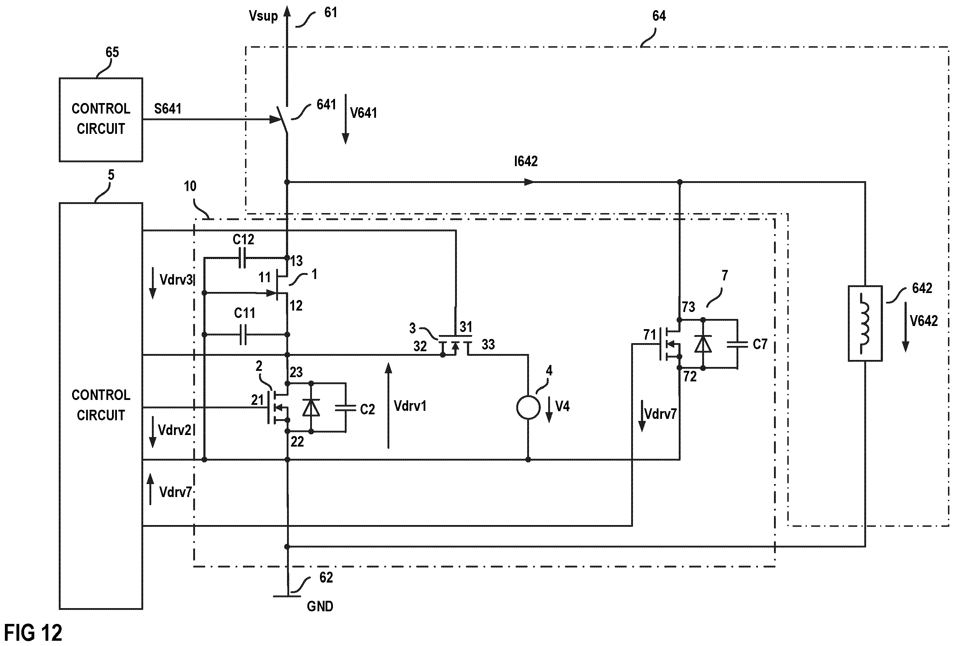

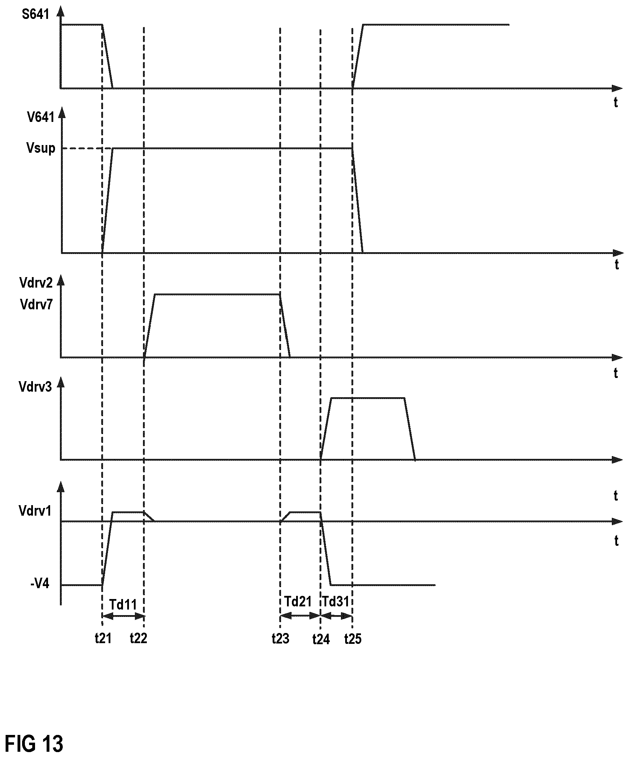

The switching circuit according to Figure 11 may be used as a rectifier element in the same way as the switching circuit 10 in the electronic circuit according to Figure 8. This is explained with reference to Figures 12 and 13 in the following.

Figure 12 shows an electronic circuit of the type illustrated in Figure 8 that includes a load circuit 64 with an electronic switch 641 and an inductor circuit 642, and a switching circuit 10 of the type illustrated in Figure 11. The optional IGBT 81 and the optional diode 82 are not illustrated in Figure 12. The functionality of the IGBT 81 and the diode 82, however, is briefly explained herein further below.

Figure 13 shows timing diagrams that illustrate operation of the electronic circuit according to Figure 12. More specifically, Figure 13 shows timing diagrams of the drive signal S641 received by the electronic switch 641, the voltage V641 across the electronic switch, and drive voltages Vdrv1, Vdrv2, Vdrv3, Vdrv7 of the first, second, third, and fourth transistor devices 1, 2, 3, 7. The drive voltage Vdrv7 is generated by the control circuit 5. According to one example (illustrated in Figure 13), the drive voltages Vdrv2, Vdrv7 of the second and fourth transistor devices 2, 7 are different drive signals, although the second and fourth transistor devices 2, 7 may be operated synchronously. According to another example (not illustrated) the same drive signal, such as the second drive signal Vdrv2, drives the second transistor device 2 and the fourth transistor devices 7.

Operating the switching circuit according to Figure 11 is similar to operating the switching circuit according to Figure 8. During the on-state of the electronic switch 641 the load current I642 flows through the series circuit including the electronic switch 641 and the inductor circuit 642, wherein the voltage V642 across the inductors circuit 642 essentially equals the supply voltage. The on-state of the electronic switch 641 is illustrated in Figure 13 before a first time instance t21. The switching circuit 10 is in the off-state when the electronic switch 641 is in the on-state. This includes that the fourth transistor device 7 and the optional IGBT 81 are in the off-state and the second transistor device 2 is in the off-state, thereby causing the cascode circuit with the first and second transistor devices 1, 2 to be in the off-state.

Referring to Figure 13, when the electronic switch 641 switches off at the first time instance t21, the switching circuit 10 takes over the load current 1642 and acts as a freewheeling circuit or rectifier circuit. This includes that the cascode circuit and the fourth transistor device 7 each conduct a portion of the load current I642. During a first delay time Td11, which is between the first time instance t21 and a second time instance t22 at which the switching circuit 10 switches on, the switching circuit 10 operates in a diode mode (diode state). This includes that the body diode of the second transistor device 2 and the body diode of the fourth transistor devices 7 are conducting. This operating state is referred to as a diode state or diode mode of the switching circuit 10 in the following.

The conducting body diode of the second transistor device 2 causes the cascode circuit to conduct and take over a portion of the load current I642. Switching on the switching circuit 10 at the second time instance t22 includes switching on the second transistor device 2 and the fourth transistor device 7. In the on-state of the switching circuit 10 the switching circuit 10 further conducts the load current I642. Conduction losses in the on-state, however, are lower as conduction losses in the diode state.

With regard to a first delay time Td11 between the first and second time instances t21, t22 everything explained hereinabove with regard to the first delay time Td1 illustrated in Figure 9 applies accordingly.

Referring to Figure 13, at a third time instance t23, which is before a fifth time instance t25 at which the electronic switch 641 again switches on, the switching circuit 10 switches off and enters the diode state. Switching off the switching circuit 10 includes switching off the first transistor device 2 and switching off the fourth transistor device 7, so that the body diode of the second transistor device 2 and the conducting first transistor device 1 on one side and the body diode of the fourth transistor device 7 on the other side take over the load current I642.

Referring to Figure 13, at a fourth time instance t24, which is before the fifth time instance t25, the third transistor device 3 switches on. With regard to a second delay time Td21 between the third and fourth time instances t23, t24 everything explained with regard to the second delay time Td2 illustrated in Figure 9 applies accordingly. With regard to a third delay time Td31 between the fourth and fifth time instances t24, t25 everything explained with regard to the third delay time Td3 illustrated in Figure 9 applies accordingly.

When the third transistor device 3 switches on at the fourth time instance t24 it connects the voltage source 4 in parallel with the load path of the second transistor device 2 so that, as explained before, the capacitances C 11, C2 of the first and second transistor devices 1, 2 are charged and the first and second transistor devices 1, 2 are transferred into the blocking state. During the process of transferring the first and second transistor devices 1, 2 into the blocking state, an output capacitance C7 between the first and second load path nodes 72, 73 of the fourth transistor devices 7 is also charged by the voltage source 4, wherein the charging current flows from the voltage source 4 via the third transistor device 3 and the first transistor device 1 to the capacitance C7 of the first transistor device 7.

In the same way as charging the capacitances C11, C2 of the first and second transistor devices 1, 2 by the voltage source 4 instead of the supply voltage source providing the supply voltage Vsup, charging the capacitance C7 of the fourth transistor 7 by the voltage source 4 reduces losses associated with charging the capacitance C7 as compared to charging the capacitance C7 by the supply voltage source.

After the electronic switch 641 has been switched on at the fifth time instance t25 the capacitance C7 of the fourth transistor devices 7 is further charged by the supply voltage source until the voltage across the capacitance C7 essentially reaches the supply voltage Vsup. This charging process is associated with further losses. The output capacitance of a MOSFET, in particular the output capacitance of a superjunction MOSFET, however, is highly nonlinear in such a way that the output capacitance is high when the voltage across the load path is low and decreases as the voltage across the load path increases. Referring to the above, the output capacitance of the first transistor device 7 is already charged to a certain extent by the voltage source 4 before the electronic switch 641 switches on. The voltage provided by the voltage source 4 is lower than the supply voltage. Due to the nonlinear output capacitance C7 a substantial portion of an overall charge that is included in the output capacitance C7 when the voltage across the load path equals the supply voltage is already provided by the voltage source 4, so that switching losses are reduced as compared to a switching circuit that would only include the fourth transistor device 7.

In the switching circuit 10 according to Figure 12, the circuit portion including the cascode circuit with the first and second transistor devices 1, 2 and the series circuit including the third transistor device 3 and the voltage source 4 not only reduces switching losses occurring in the fourth transistor devices 7, but, in the on-state of the switching circuit 10, provides a conducting path in parallel to the fourth transistor device 7, so that this circuit portion not only reduces switching losses but also contributes to a reduction of the conduction losses.

When the switching circuit 10 includes the optional diode 82, the circuit portion including the cascode circuit 1, 2 and the series circuit 3, 4 not only charges the output capacitance C7 of the fourth transistor device 7 but also charges a parasitic capacitance of the diode, thereby reducing switching losses as compared to charging this parasitic capacitance by the supply voltage source.

As explained, in a switching circuit 10 of the type illustrated in Figure 11, the cascode circuit including the first and second transistor devices 1, 2 and the fourth transistor device 7 may be switched on and off synchronously. This may include switching on and off the second transistor device 2 and the fourth transistor device 7 synchronously. In the event that the switching circuit 10 additionally includes the IGBT 81, the IGBT 81 may be switched on and off synchronically with the second and fourth transistor devices 2, 7. It is commonly known that an IGBT includes an internal PN junction in the load path (collector-emitter path), which has the effect that a voltage across a conducting IGBT at least equals a forward voltage of the PN junction, wherein the forward voltage is about 0.7 V in a silicon (Si) IGBT. This has the effect that in the switching circuit according to Figure 11 the IGBT 81 starts to conduct when a load current through the parallel circuit including the fourth transistor device 7 and the cascode circuit is high enough for a voltage across the parallel circuit to reach the forward voltage of the IGBT 81. Thus, under low load conditions, which are operating conditions in which the voltage across the parallel circuit is below the forward voltage of the IGBT 81, the IGBT 81, even in the on-state, does not conduct. Under high load conditions, which are operating conditions in which the voltage across the parallel circuit is higher than the forward voltage of the IGBT 81, the IGBT 81 conducts a current in the on-state.

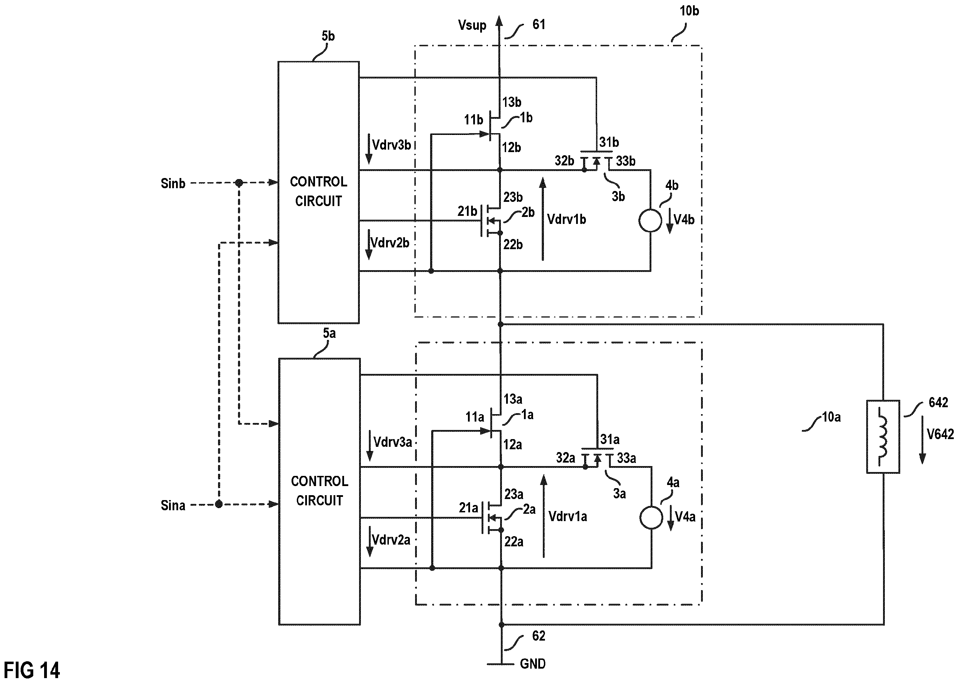

Figure 14 illustrates an electronic circuit of the type illustrated in Figure 8, that includes a first switching circuit 10a and a second switching circuit 10b of the type illustrated in Figure 1. In the electronic circuit according to Figure 14, the first and second switching circuits 10a, 10b form a half-bridge in which the first switching circuit 10a acts as a low-side switch and has the same function as the switching circuit 10 in the electronic circuit according to Figure 8. The second switching circuit 10b acts as a high-side switch and has the same function as the electronic switch 641 in the electronic circuit according to Figure 8. The first switching circuit 10a acts as a low-side switch and a rectifier element. The first and second switching circuits 10a, 10b are implemented in the same way as the switching circuit 10 according to Figure 1, wherein like parts and signals have same reference numbers added by "a" in the first switching circuit 10a and added by "b" in the second switching circuit 10b. The inductor circuit 642 connected in parallel with the second switching circuit 10a may be implemented in accordance with any of the examples of the inductor circuit 642 explained herein before.

Furthermore, a first control circuit 5a is configured to control operation of the first switching circuit 10a, and a second control circuit 5b is configured to control operation of the second switching circuit 10b. More specifically, the first control circuit 5a is configured to generate the drive signals Vdrv2a, Vdrv3a received by the second and third transistor devices 2a, 3a in the first switching circuit 10a, and the second control circuit 5b is configured to generate the drive signals Vdrv2b, Vdrv3b received by the second and third transistor devices 2b, 3b in the second switching circuit 10b.

According to one example illustrated in dashed lines in Figure 14, the first and second control circuits 5a, 5b are configured to generate the respective drive signals Vdrv2a, Vdrv3a, Vdrv2b, Vdrv3b based on first and second control signals Sina, Sinb received by each of the first and second control circuits 5a, 5b. In order to avoid a cross current, the first and second control signals Sina, Sinb are provided in such a way and the drive signals Vdrv2a, Vdrv3a, Vdrv2b, Vdrv3b are generated based on the first and second control signals Sina, Sinb in such a way that the cascode circuits in the first and second switching circuits 10a, 10b are not in the on-state at the same time.

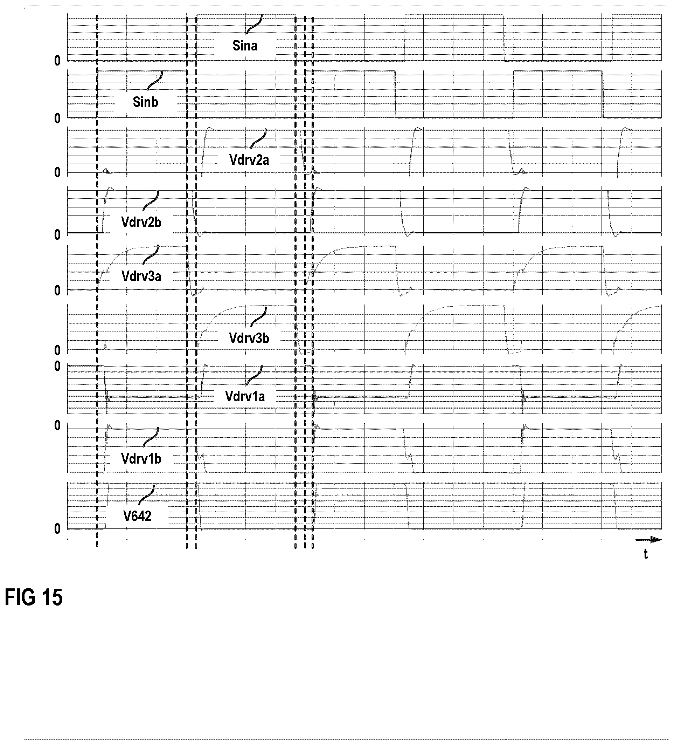

According to one example, the first control signal Sina governs switching on and switching off the cascode circuit with the first and second transistor devices 1a, 2a in the first switching circuit 10a and governs switching on and switching off the third transistor device 3b in the second switching circuit 10b. Equivalently, the second control signal Sinb governs switching on and switching off the cascode circuit with the first and second transistor devices 1b, 2b in the second switching circuit 10b and governs switching on and switching off the third transistor device 3a in the first switching circuit 10b. This is explained with reference to signal diagrams illustrated in Figure 15 in the following.

Figure 15 shows signal diagrams that illustrate one example for operating the electronic circuit according to Figure 14. More specifically, Figure 15 shows signal diagrams of the first and second control signals Sina, Sinb, the drive signals Vdrv2a, Vdrv3a, Vdrv2b, Vdrv3b generated by the first and second control circuits 5a, 5b based on the first and second control signals Sina, Sinb and the drive signals Vdrv1a, Vdrv1b received by the respective first transistor device 1a, 1b in the first and second switching circuits 10a, 10b.

Referring to the above, the first control signal Sina governs switching on and switching off of the cascode circuit 1a, 2a in the first switching circuit 10a and the third transistor device 3b in the second switching circuit 10b, and the second control signal Sinb governs switching on and switching off of the cascode circuit 1b, 2b in the second switching circuit 10a and the third transistor device 3a in the first switching circuit 10a. Each of the first and second control signals Sina, Sinb has an on level or an off-level. The on-level is a signal level indicating that it is desired to switch on the respective cascode circuit 1a, 2a, 1b, 2b and the respective third transistor device 3b, 3a and the off-level is a signal level indicating that is desired to switch off the respective cascode circuit 1a, 2a, 1b, 2b and the respective third transistor device 3b, 3a. Just for the purpose of illustration, in the example illustrated in Figure 15, the on-level of the first and second control signals Sina, Sinb is a high signal level and the off-level is a low signal level.

The signal diagrams illustrated in Figure 15 refer to an example in which the first transistor devices 1a, 1b are N-type depletion transistor devices having a negative threshold voltage. In this example, an on-level of the first drive voltages Vdrv1a, Vdrv1b, which is a signal level that switches on the first transistor devices 1a, 1b, is a signal level that is higher than the negative threshold voltage. In the example illustrated in Figure 15, the on-level equals zero. Furthermore, the off-level of the first drive voltages Vdrv1a, Vdrv1b, which is a signal level that switches off the first transistor devices 1a, 1b, is a signal level that is lower than the negative threshold voltage. This signal level equals the negated respective depletion voltage V4a, V4b when the respective third transistor device 3a, 3b is in the on-state.

Furthermore, the signal diagrams illustrated in Figure 15 refer to an example in which the second and third transistor devices 1a, 1b, 3a, 3b are N-type enhancement transistor devices having a positive threshold voltage, so that on-level of the respective drive signal Vdrv1a, Vdrv1b, Vdrv3a, Vdrv3b is a signal level higher than the threshold voltage and the off-level of the respective drive signal Vdrv1a, Vdrv1b, Vdrv3a, Vdrv3b is a signal level lower than the threshold voltage. In the example illustrated in Figure 15, the off level essentially equals zero.

Referring to Figure 15, the first and second control signals Sina, Sinb alternatingly have an on-level for a predefined time period such that the first and second control signal Sina, Sinb do not have an on-level at the same time. Furthermore, there is a dead time between the first and second control signals Sina, Sinb such that each of the control signals Sina, Sinb has an off-level for a predefined time period after the signal level of one of the control signals Sina, Sinb has changed from the on-level to the off-level and before the other one of the control signals Sina, Sinb changes from the off-level to the on-level. Furthermore, referring to Figure 15, there is a delay time between the time instance at which one of the control signals Sina, Sinb changes from the off-level to the on-level and the time instance at which the respective second drive signal Vdrv2a, Vdrv2b changes from the off-level to the on-level, and there is a delay time between the time instance at which one of the control signals Sina, Sinb changes from the on-level to the off-level and the time instance at which the respective second drive signal Vdrv2a, Vdrv2b changes from the on-level to the off-level. The dead time between the control signals Sina, Sinb and the delay times are selected such that the second drive signals Vdrv2a, Vdrv2b do not have the on-level at the same time, so that the cascode circuits 1a, 2a, 1b, 2b do not conduct at the same time.

Furthermore, as can be seen from Figure 15, the third transistor device 3a, 3b of each of the first and second switching circuits 10a, 10b is switched on by the on-level of the respective drive signal Vdrv3a, Vdrv3b after the respective second transistor device 2a, 2b has been switched off by the off-level of the respective drive signal Vdrv2a, Vdrv2b. As can be seen from Figure 15, in each case, in one of the first and second switching circuits 10a, 10b the third transistor device 3a, 3b switches on to connect the respective depletion voltage source 4a, 4b in parallel with the respective second transistor device 2a, 2b before the second transistor device 2a, 2b in the other one of the first and second switching circuits 10a, 10b switches on. Thus, in the first switching circuit 10a, for example, the depletion voltage source 4a is connected in parallel with the load path of the second transistor device 2a before the second transistor device 2b in the second switching circuit 10b switches on the cascode circuit 1b, 2b and the voltage V642 (which is also illustrated in Figure 15) across the first switching circuit 10a increases.

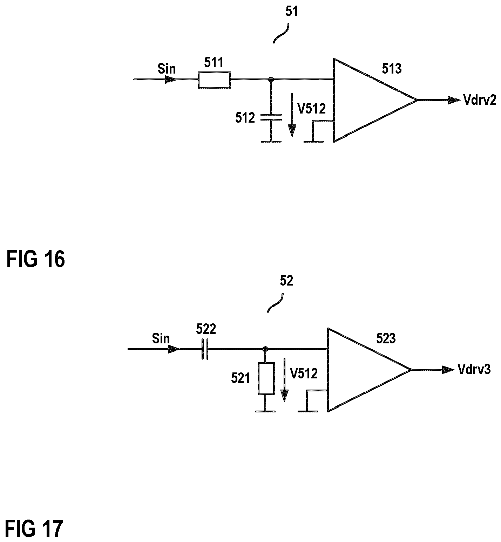

Figure 16 illustrates a control unit 51 that may be included in each of the first and second control circuits 5b, 5b to generate the second drive voltages Vdrv2a, Vdrv2b dependent on the respective first or second input signal Sina, Sinb. In Figure 16, Sin denotes an arbitrary one of the first and second control signals Sina, Sinb, and Vdrv2 denotes the respective second drive voltage Vdrv2a, Vdrv2b. Referring to Figure 16, the drive unit 51 includes an RC circuit with a resistor 511 and a capacitor 512 that are connected in series. The control signal Sin is a voltage across the series circuit including the resistor 511 and the capacitor 512. Furthermore, the control unit 51 includes a drive circuit 513 that is configured to receive the voltage across the capacitor 512 and provide the drive voltage Vdrv2 dependent on the voltage V512 across the capacitor 512.

Figure 17 illustrates a control unit 52 that may be included in each of the first and second control circuit 5a, 5b to generate the third drive voltages Vdrv3a, Vdrv3b dependent on the respective first or second input signal Sina, Sinb. In Figure 17, Sin denotes an arbitrary one of the first and second control signals Sina, Sinb, and Vdrv3 denotes the respective third drive voltage Vdrv3a, Vdrv3b. Referring to Figure 17, the drive unit 52 includes a CR circuit with a capacitor 522 and a resistor 521 that are connected in series. The control signal Sin is a voltage across the series circuit including the capacitor 522 and the resistor 521. Furthermore, the control unit 52 includes a drive circuit 523 that is configured to receive the voltage across the resistor 521 and provide the drive voltage Vdrv3 dependent on a voltage V521 across the resistor.

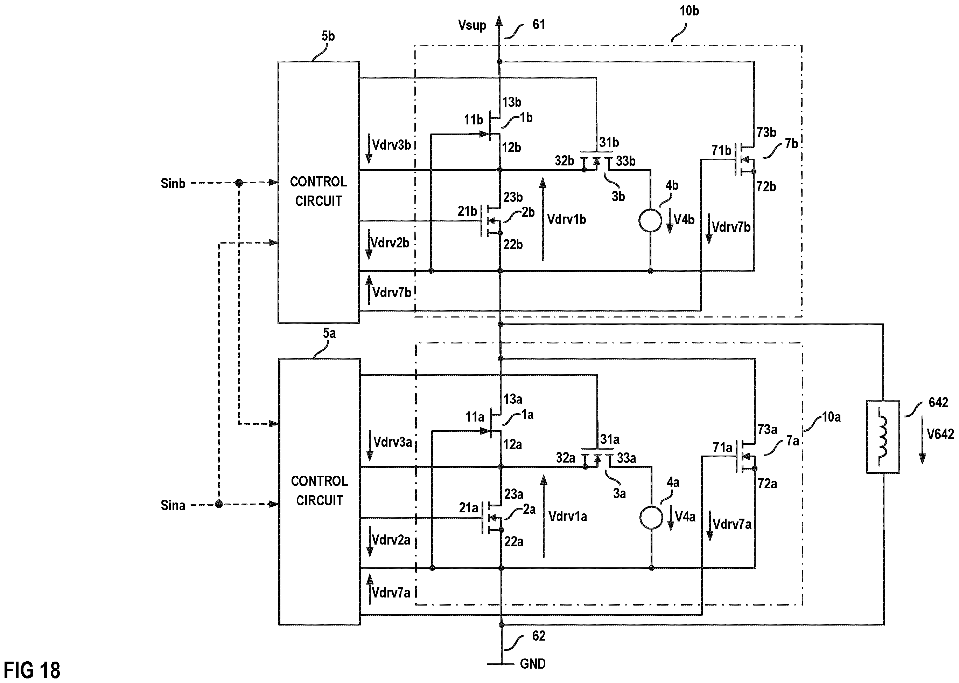

Figure 18 illustrates a modification of the electronic circuit according to Figure 15. The electronic circuit according to Figure 18 is different from the electronic circuit according to Figure 15 in that the first and second switching circuits 10a, 10b are implemented in accordance with the switching circuit illustrated in Figure 11. That is, each of the first and second switching circuits 10a, 10b includes a fourth transistor device 7a, 7b that has its load path connected in parallel with the respective cascode circuit 1a, 2a, 1b, 2b.

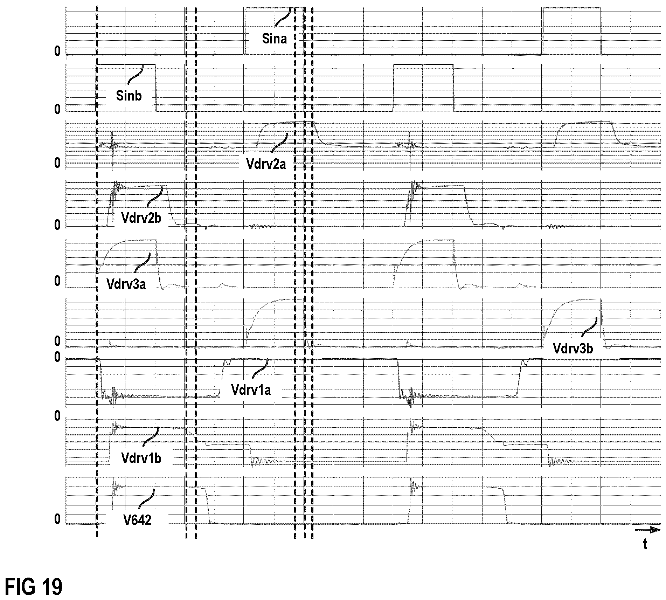

Figure 19 shows signal diagrams that illustrate operation of the electronic circuit according to Figure 18. Figure 19 shows the same signal diagrams as illustrated in Figure 15. The fourth drive signals Vdrv7a, Vdrv7b may be equal to the second drive signals Vdrv2a, Vdrv2b. For the purpose of illustration, the signal diagrams illustrated in Figure 19 are different from the signal diagrams illustrated in Figure 15 in that the dead times between on levels of the first and second control signals Sina, Sinb are longer in the example illustrated in Figure 19 then in the example illustrated in Figure 15.

As can be seen from Figure 19, in each case, before one of the cascode circuits 1a, 2a, 1b, 2b in one of the first and second switching circuits 10a, 10b is switched on by the respective second drive signal Vdrv2a, Vdrv2b, the third transistor device 3b, 3b of the other one of the first and second switching circuits 10a, 10b connects the depletion voltage source 4a, 4b in parallel with the load path of the respective second transistor device 2a, 2b. In particular, after the cascode circuit 1a, 2a of the first switching circuit 10a has been switched off and before the cascode circuit 1b, 2b of the second switching circuit 10b switches on and the voltage 642 across the first switching circuit 10a increases, the third transistor device 3a of the first switching circuit 10a switches on. In this way, the negated depletion voltage V4a is applied across the load path of the second transistor device 2a and to the drive input of the first transistor device 1a, in order to reduce switching losses in the way explained herein before.

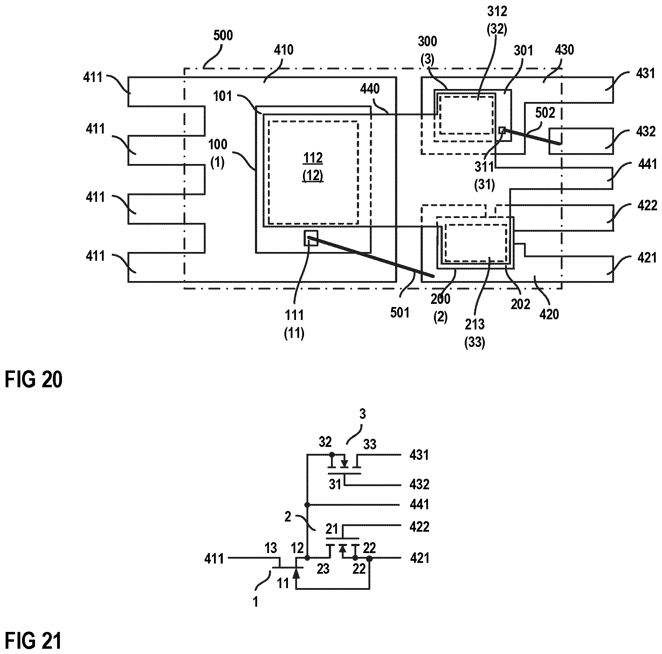

Figure 20 illustrates one example of a semiconductor package that includes a circuit arrangement with a first transistor device 1, a second transistor device 2, and a third transistor device 3 of the type explained herein before. Figure 21 illustrates an equivalent circuit diagram of the semiconductor package according to Figure 20. The semiconductor package illustrated in Figure 20 provides for a low-ohmic and low-inductive connection between the transistor devices 1, 2, 3.

In the semiconductor package according to Figure 20, each of the transistor devices 1, 2, 3 is integrated in a respective semiconductor body (semiconductor die). The first transistor device 1 is integrated in a first semiconductor body 100, the second transistor device 2 is integrated in a second semiconductor body 200, and the third transistor device 3 is integrated in a third semiconductor body 300. Each of the transistor devices 1, 2, 3 is a vertical transistor device. That is, each of the transistor devices 1, 2, 3 includes a source pad at a first surface of the respective semiconductor body 100, 200, 300 and a drain pad at a second surface opposite the first surface of the respective semiconductor body 100, 200, 300. The source pad forms the source node 12, 22, 23 of the respective transistor device 1, 2, 3, and the drain pad forms the drain node 13, 23, 33 of the respective transistor device 1, 2, 3.

Figure 20 shows a top view of the semiconductor arrangement. The semiconductor bodies 100, 200, 300 are arranged such that the first surface 101 with the source pad 112 of the first semiconductor body 100, the second surface 202 with the drain pad 213 of the second semiconductor body 200, and the first surface 301 with the source pad 312 of the third semiconductor body 300 are visible in Figure 20.

The semiconductor package includes three electrically conducting carriers 410, 420, 430, such as lead frames. The first semiconductor body 100 is arranged on top of a first carrier 410 such that the second surface of the first semiconductor body 100 faces the first carrier 410 and the drain pad arranged at the second surface is electrically connected to the first carrier 410. Thus, the first carrier 410 is connected to the drain node 13 of the first transistor device 1. The second semiconductor body 200 is arranged on top of a second carrier 420 such that the first surface of the second semiconductor body 200 faces the second carrier 420 and the source pad of the second semiconductor body 200 arranged at the first surface is electrically connected to the second carrier 420. The third semiconductor body 300 is arranged on top of a third carrier 430 such that the second surface of the third semiconductor body 300 faces the third carrier 430 and the drain pad of the third semiconductor body 300 arranged at the second surface is electrically connected to the third carrier 430.

Referring to Figure 20, the semiconductor package may further include a housing 500 in which the semiconductor bodies 100, 200, 300 are arranged and in which the carriers 410, 420, 430 are partially arranged. The housing 500 includes a mold compound, for example. "Partially arranged" in this context includes that each of the carriers 410, 420, 430 includes at least one electrically conducting leg 411, 431, 421 that protrudes from the housing. Via the at least one leg 411 of the first carrier 410, the drain node 13 of the first transistor device 1 is electrically accessible from outside the housing 500. Via the at least one leg 421 of the second carrier 420, the source node 22 of the second transistor device 2 is electrically accessible from outside the housing 500. Via the at least one leg 431 of the third carrier 430, the drain node 33 of the third transistor device 3 is electrically accessible from outside the housing 500.

Each of the transistor devices further includes a gate pad that forms a gate node 11, 12, 13 of the respective transistor device 1, 2, 3. According to one example, the gate pads are formed at the first surface of the respective semiconductor body 100, 200, 300. In the example illustrated in Figure 20, the gate pad 111 of the first transistor device 1 formed at the first surface 101 of the first semiconductor body 100 and the gate pad 311 of the third transistor device 3 formed at the first surface 301 of the third semiconductor body 300 are visible. The gate pad of the second transistor device formed at the first surface of the second semiconductor body 200 is out of view in Fig-ure 20.

Referring to Figure 20, the gate pad 111 of the first transistor device 1 is electrically connected to the second carrier 420 and is electrically connected to the source pad of the second transistor device 2 via the second carrier 420. The gate pad 111 of the first transistor device 1 is connected to the second carrier 420 through a conductor such as, for example, a bond wire, a clip, or the like.

The gate pad 311 of the third transistor device 3 is electrically connected to an electrically conducting contact leg 432 by a conductor 501. The contact leg 432 protrudes from the housing 500. The contact leg 432 makes the gate node 31 of the third transistor device 3 electrically accessible from outside the housing 500. The conductor 502 is a bond wire, a clip, or the like, for example.

Furthermore, the gate pad of the second transistor device 2 is electrically connected to a further contact leg 422 that protrudes from the housing 500. According to one example, the further contact leg 422 is directly connected to the gate pad of the second transistor device 2. This gate pad is out of view in Figure 20. The further contact leg 422 makes the gate node 12 of the second transistor device 2 electrically accessible from outside the housing 500.

Referring to Figure 20, the source pad 112 of the first transistor device 1, the source pad 312 of the third transistor device 3, and the drain pad 213 of the second transistor device 2 are electrically connected with each other by a conductor 440. This conductor 440 is a flat conductor, such as a clip, for example and provides for a low ohmic and low inductive connection between the source pads 112, 312 and the drain pad 213.

Some of the aspects explained above are briefly summarized in the following with reference to numbered examples.

Example 1. An electronic circuit including a switching circuit, wherein the switching circuit includes: a first transistor device including a control node and a load path between a first load path node and a second load path node; a second transistor device including a control node and a load path between a first load path node and a second load path node; and a series circuit including a third transistor device and a voltage source connected in series with a load path of the third transistor device, wherein the first transistor device is a normally-on device, wherein the second transistor device is a normally-off device, wherein the load paths of the first and second transistor devices are connected in series, wherein the load path of the second transistor device is connected between the control node and the first load path node of the first transistor device, and wherein the series circuit is connected in parallel with the load path of the second transistor device.

Example 2. The electronic circuit according to example 1, wherein the first transistor device is a JFET.

Example 3. The electronic circuit according to example 2, wherein the JFET is a SiC JFET.

Example 4. The electronic circuit according to any one of examples 1 to 3, wherein at least one of the second transistor device and the third transistor device is a MOSFET.

Example 5. The electronic circuit according to any one of examples 1 to 4, wherein the switching circuit further includes: at least one further transistor device having a load path, wherein the load path of the at least one further transistor device is connected in parallel with a series circuit including the load paths of the first and second transistor devices connected in series.

Example 6. The electronic circuit according to example 5, wherein the at least one further transistor device includes a MOSFET.

Example 7. The electronic circuit according to example 6, wherein the MOSFET is a superjunction MOSFET.

Example 8. The electronic circuit according to example 5, wherein the at least one further transistor device includes an IGBT.

Example 9. The electronic circuit according to any one of examples 1 to 8, wherein the series circuit further includes a resistor connected in series with the third transistor device and the voltage source.

Example 10. The electronic circuit of any one of examples 1 to 9, further including: a control circuit configured to control on-states and off-states of the second transistor device and the third transistor device.

Example 11. The electronic circuit of example 10, wherein the control circuit is configured to operate the third transistor device in the off-state when the second transistor device is in the on-state and to operate the third transistor device in the on-state after the second transistor device has changed from the on-state to the off-state.

Example 12. The electronic circuit of example 11, further including: an electronic switch connected in series with the first and second transistor devices, wherein the control circuit is further configured to operate the third transistor device in the on-state before the electronic switch changes from an off-state to an on-state.

Example 13. The electronic circuit of examples 5 and 10, wherein the control circuit is further configured to operate the at least one further transistor device in on-states and off-states synchronously with the second transistor device.

Example 14. The electronic circuit of any one of examples 1 to 13, wherein the first transistor device is integrated in a first semiconductor body, the second transistor device is integrated in a second semiconductor body and the third transistor device is integrated in a third semiconductor body, and wherein the first semiconductor body, the second semiconductor body, and the third semiconductor body are arranged in a common integrated circuit package.

Example 15. The electronic circuit of example 14, wherein the first semiconductor body is arranged on top of a first carrier, the second semiconductor body is arranged on top of a second carrier, and the third semiconductor body is arranged on top of a third carrier, wherein the first carrier, the second carrier, and the third carrier are spaced apart from each other.

Example 16. A half bridge circuit including: a first electronic circuit according to any one of examples 1 to 8; and a second electronic circuit according to any one of examples 1 to 8, wherein the load paths of the first transistor device and the second transistor device of the first switching circuit and the load paths of the first transistor device and the second transistor device of the second switching circuit are connected in series.

Example 17. A power converter, including: an inductor, an electronic switch, and a rectifier, wherein at least one of the electronic switch and the rectifier is implemented as a switching circuit in accordance with any one of examples 1 to 9.

Example 18. The power converter according to example 17, wherein both the electronic switch and the rectifier are implemented as a switching circuit in accordance with any one of examples 1 to 9.

Example 19. A method, including: controlling a switching circuit, wherein the switching circuit includes: a first transistor device including a control node and a load path between a first load path node and a second load path node; a second transistor device including a control node and a load path between a first load path node and a second load path node; and a series circuit including a third transistor device and a voltage source connected in series with a load path of the third transistor device, wherein the first transistor device is a normally-on device, wherein the second transistor device is a normally-off device, wherein the load paths of the first and second transistor devices are connected in series, wherein the load path of the second transistor device is connected between the control node and the first load path node of the first transistor device, and wherein the series circuit is connected in parallel with the load path of the second transistor device, and wherein the method includes: operating the third transistor device in the off-state when the second transistor device is in the on-state; and operating the third transistor device in the on-state after the second transistor device has changed from the on-state to the off-state.

## Claims

1. An electronic circuit comprising a switching circuit (10),
wherein the switching circuit (10) comprises:
a first transistor device (1) comprising a control node (11) and a load path between a first load path node (12) and a second load path node (13);
a second transistor device (2) comprising a control node (21) and a load path between a first load path node (22) and a second load path node (23); and
a series circuit comprising a third transistor device (3) and a voltage source (4) connected in series with a load path of the third transistor device (3),
wherein the first transistor device (1) is a normally-on device,
wherein the second transistor device (2) is a normally-off device,
wherein the load paths of the first and second transistor devices (1, 2) are connected in series,
wherein the load path of the second transistor device (2) is connected between the control node (11) and the first load path node (12) of the first transistor device (1), and
wherein the series circuit is connected in parallel with the load path of the second transistor device (2).

2. The electronic circuit according to claim 1,
wherein the first transistor device (1) is a JFET.

3. The electronic circuit according to claim 2,
wherein the JFET is an SiC JFET.

4. The electronic circuit according to any one of the preceding claims,
wherein at least one of the second transistor device (2) and the third transistor device (3) is a MOSFET.

5. The electronic circuit according to any one of the preceding claims, wherein the switching circuit (10) further comprises:
at least one further transistor device (7, 8) having a load path,
wherein the load path of the at least one further transistor device (7, 8) is connected in parallel with a series circuit including the load paths of the first and second transistor devices (1, 2) connected in series.

6. The electronic circuit according to claim 5,
wherein the at least one further transistor device comprises a MOSFET (7).

7. The electronic circuit according to claim 6,
wherein the MOSFET (7) is a superjunction MOSFET.

8. The electronic circuit according to claim 5,
wherein the at least one further transistor device comprises an IGBT (8).

9. The electronic circuit according to any one of the preceding claims,
wherein the series circuit further comprises a resistor (41) connected in series with the third transistor device (3) and the voltage source (4).

10. The electronic circuit of any one of the preceding claims, further comprising:
a control circuit (5) configured to control on-states and off-states of the second transistor device (2) and the third transistor device (3).

11. The electronic circuit of claim 10,
wherein the control circuit (5) is configured to operate the third transistor device (3) in the off-state when the second transistor device (2) is in the on-state and to operate the third transistor device (3) in the on-state after the second transistor device (2) has changed from the on-state to the off-state.

12. The electronic circuit of claim 11, further comprising:
an electronic switch (641; 10b) connected in series with the first and second transistor devices (1, 2),
wherein the control circuit (5) is further configured to operate the third transistor device (3) in the on-state before the electronic switch (641) changes from an off-state to an on-state.

13. A half bridge circuit comprising:
a first electronic circuit (10a) according to any one of claims 1 to 8; and
a second electronic circuit (10b) according to any one of claims 1 to 8,
wherein the load paths of the first transistor device (1a) and the second transistor device (2a) of the first switching circuit (10a) and the load paths of the first transistor device (1b) and the second transistor device (2b) of the second switching circuit (10b) are connected in series.

14. A power converter, comprising:
an inductor (631; 642), an electronic switch, and a rectifier,
wherein at least one of the electronic switch and the rectifier is implemented as a switching circuit in accordance with any one of claims 1 to 9.

15. A method, comprising:
controlling a switching circuit,
wherein the switching circuit (10) comprises:
a first transistor device (1) comprising a control node (11) and a load path between a first load path node (12) and a second load path node (13);
a second transistor device (2) comprising a control node (21) and a load path between a first load path node (22) and a second load path node (23); and
a series circuit comprising a third transistor device (3) and a voltage source (4) connected in series with a load path of the third transistor device (3),
wherein the first transistor device (1) is a normally-on device,
wherein the second transistor device (2) is a normally-off device,
wherein the load paths of the first and second transistor devices (1, 2) are connected in series,
wherein the load path of the second transistor device (2) is connected between the control node (11) and the first load path node (12) of the first transistor device (1), and
wherein the series circuit is connected in parallel with the load path of the second transistor device (2), and
wherein the method comprises:
operating the third transistor device (3) in the off-state when the second transistor device (2) is in the on-state; and
operating the third transistor device (3) in the on-state after the second transistor device (2) has changed from the on-state to the off-state.
